Europäisches Patentamt

European Patent Office

Office européen des brevets

(11) Publication number: **0 374 490**
**A2**

# EUROPEAN PATENT APPLICATION

(21) Application number: 89121333.2

(22) Date of filing: 17.11.89

(51) Int. Cl.5: **H03K 5/24**

(30) Priority: 21.12.88 IT 2304188

(43) Date of publication of application:
27.06.90 Bulletin 90/26

(84) Designated Contracting States:
DE FR GB NL SE

(71) Applicant: SGS-THOMSON
MICROELECTRONICS s.r.l.
Via C. Olivetti, 2
I-20041 Agrate Brianza Milano(IT)

(72) Inventor: Menegoli, Paolo
16220 N 7th Street
1139 Phoenix,AZ 85022(US)
Inventor: Morelli, Marco
Via T. Guerrazzi, 71
I-57100 Livorno(IT)

(74) Representative: Perani, Aurelio et al
c/o JACOBACCI-CASETTA & PERANI S.p.A 7,
Via Visconti di Modrone
I-20122 Milano(IT)

(54) A voltage comparator circuit for intergrated circuit drivers of inductive electric loads.

(57) A voltage comparator circuit for integrated circuit drivers of electric loads, being of a type operative to compare voltage values appearing at a pole pair of the driver, comprises first (T9) and second (T10) transistors, both of the NPN type, having their respective bases (B9,B10) connected together into a differential cell configuration and respective emitters (E9,E10) connected each to a corresponding pole (5,6). Such transistors have their respective collectors (C9,C10) connected to the input side of the driver circuit and enable a comparison to be performed between said poles even where negative voltage values appear on both of them.

EP 0 374 490 A2

This invention relates to a voltage comparator circuit for drivers of electric loads, being of a type operative to compare the voltage values appearing on a pole pair of the driver.

A recognized demand of driver circuits of electric loads, specifically inductive loads, is that two nodes of the circuit can be compared voltage-wise so as to better control the value of the current flowing through the load during the feedback phase.

This demand grows critical where the voltage values appearing at both of said points are below ground value.

The prior art only provides conventional design comparators, generally comprising PNP transistors, which have shown to be unable to meet said demand. In addition, due to the presence of parasitic components (diodes) between the bases and the substrate of the PNP transistors, such comparators have a small dunamic range.

In short, no known technical solution is currently available which can meet said demand where the voltage values present on both said nodes are negative ones.

The greatest difficulty to be overcome, if this problem is to be given a solution, is that a circuit should in all cases operate between a positive voltage supply pole and ground in order to perform the comparison.

The technical problem that underlies this invention is to provide a voltage comparator circuit for drivers of inductive electric loads, which has such structural and performance characteristics as to enable a comparison to be performed between two voltage poles which are both apt to show negative voltage values, thus filling a gap in the prior art.

This problem is solved by a comparator circuit as indicated being characterized in that it comprises first and second transistors, both of the NPN type, having their respective bases interconnected differential cell-fashion and their respective emitters connected each to a corresponding pole, said transistors having their respective collectors connected to the input side of the driver circuit to compare negative voltage values on said poles and control the current flowing through the electric load.

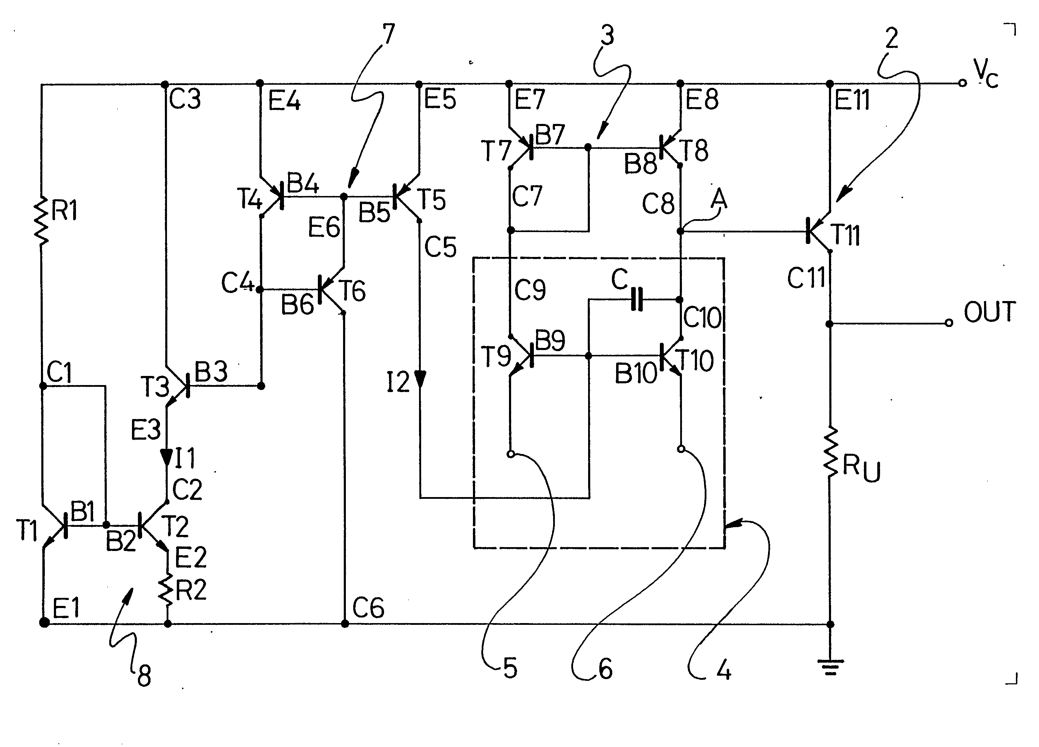

The features and advantages of the circuit according to the invention will be apparent from the following detailed description of an embodiment thereof, given by way of illustration and not of limitation with reference to the accompanying drawing.

The accompanying drawing figure shows in wiring diagram form an electric load driver circuit incorporating the comparator circuit of this invention.

With reference to the drawing figure, generally indicated at 1 is a wiring diagram of an integrated circuit operative to drive electric loads, in particular inductive loads, not shown because conventional.

The circuit 1 comprises an output stage 2 provided with an output terminal OUT which is connected to ground via a resistor RU.

The output stage 2 comprises a transistor T11 of the PNP type having its collector C11 connected to said terminal OUT and its emitter E11 connected to a positive voltage supply pole VC.

The base B11 of that transistor is connected to a node A which is an output of a differential cell 3 comprising a pair of PNP transistors T7 and T8 having their bases B7 and B8 connected to each other and corresponding emitters E7, E8 connected to the positive pole VC.

The node A is the collector C8 of the transistor T8, whilst the base B7 and collector C7 terminals of the transistor T7 are interconnected into a diode configuration.

The cell 3 constitutes the input stage of the circuit 1, and the collectors C7 and C8 are the inputs to that stage.

Connected to that stage 3 is the comparator circuit, indicated at 4, according to the invention.

The circuit 4 comprises a first transistor T9 and a second transistor T10, being both of the NPN type and having their bases B9 and B10 connected together.

The collector C9 of the first transistor is connected to the collector C7, whilst the collector C10 of the second transistor is connected to the node A, that is to the collector C8.

A capacitor C is provided between the base B10 and the collector C10.

Advantageously, the emitters E9 and E10 of that pair of transistors T9 and T10 are each connected to a respective input pole 5 and 6 for comparison of the voltage values across such poles.

Also provided in the circuit 1 is a differential cell, current mirror 7 consisting of three transistors T4, T5 and T6, all of the PNP type.

The transistors T4 and T5 have their emitters E4, E5 connected to the positive pole VC, bases B4 and B5 connected to each other and to the emitter E6 of the third transistor T6; the latter, moreover, has its base B6 connected to the collector C4 of the transistor T4 and the collector C6 connected to ground.

The collector C5 of the transistor T5 is connected to the bases B9 and B10 of the comparator 4.

A further transistor, T3, of the NPN type with the collector C3 connected to the positive pole VC, has its base B3 connected to collector C4. That transistor T3 is a current divider.

Lastly, the circuit 1 is completed by a bias current source 8 comprising a PNP transistor T1, which has its emitter E1 grounded and collector C1 connected to the positive pole VC via a resistor R1. A second NPN transistor T2 has its emitter E2 grounded through a resistor R2.

Such transistors T1 and T2 have their bases, B1 and B2, connected together, the base B1 being also connected to collector C1.

The source 8 is connected to the current mirror 7 via the connection between the collector C2 and the emitter E3.

The source 8 generates the current value I1 appearing on the emitter E3. The transistor T3 divides that current value I1 by its own coefficient beta, thereby a current value I2 = I1/beta will be applied to the input side of the current mirror 7 via the base B3.

The latter current value, I2, is applied, through the current mirror 7, to the bases B9 and B10 of the respective transistors T9 and T10 of comparator 4.

The transistor T6 is effective to make the current mirror 7 specially accurate by recovering the base current of transistors T4 and T5.

In essence, the source E8, transistor T3, and current mirror 7 are operative to bias the comparator circuit 4 and input stage 3 of the circuit 1.

If the transistors T3, T9 and T10 are made to equal dimensions, on that branch of the differential cell 3 which is conducting the same current I1 will appear as flows through the transistor T3.

As a result, the bases of the comparator transistors T9 and T10 will be applied a bias current which is constant and unrelated to voltage changes at the poles 5 and 6.

Even if the voltage at both poles 5 and 6 drops to negative values below ground voltage, the emitters E9 and E10 will also pull down to a lower voltage value than ground the voltages on the bases B9 and B10, but trigger no parasitic components.

The parasitic diodes present between the collectors and the substrate of the transistors T9 and T10 are cut off, in fact, because of the voltage on the collectors C9 and C10 staying greater than or equal to (VC - Vbe) (supply voltage - voltage drop across the base and emitter) at all times.

The comparator of this invention has proved effective at input voltage value which is approximately one Volt (sum of the collector-to-emitter voltage drop in the saturated state plus the base-to-emitter voltage drop: Vce - Vbe) less than the supply voltage, and hence, with a specially broad dynamic range.

## Claims

1. A voltage comparator circuit for drivers of electric loads, being of a type operative to compare the voltage values appearing on a pole pair of the driver, characterized in that it comprises first (T9) and second (T10) transistors, both of the NPN type, having their respective bases (B9,B10) interconnected differential-cell fashion and their respective emitters (E9,E10) connected each to a corresponding pole (5,6), said transistors having their respective collectors (C9,C10) connected to the input side of the driver circuit to compare negative voltage values on said poles (5,6) and control the current flowing through the electric load.

2. A circuit according to Claim 1, characterized in that a capacitor (C) is provided between the base (B10) and the collector (C10) of said second transistor (T10).

3. A circuit according to Claim 1, characterized in that it further comprises a bias current source (8) connected to said bases (B9,B10) through a current divider (T3) and a current mirror (7) for biasing the comparator with a current which is constant and unaffected by changes in the voltage on said poles (5,6).

4. A circuit according to Claim 3, characterized in that said current divider is a transistor (T3) of the NPN type having its emitter (E3) connected to the current source (8) and base (B3) connected to said current mirror (7).